# EUROPÄISCHE PATENTSCHRIFT

(11) **EP 0 673 548 B1**
(45) Veröffentlichungstag und Bekanntmachung des Hinweises auf die Patenterteilung: **20.06.2001**
(21) Anmeldenummer: 94902725.4
(22) Anmeldetag: 09.12.1993
(51) Int. Cl.: H01L 29/73, H01L 29/737, H01L 29/36

(54) **BIPOLARTRANSISTOR**
BIPOLAR TRANSISTOR
TRANSISTOR BIPOLAIRE

(30) Priorität: 10.12.1992 DE 4241609
(43) Veröffentlichungstag der Anmeldung: 27.09.1995
(73) Patentinhaber: ATMEL Germany GmbH, 74072 Heilbronn (DE)
(72) Erfinder: JORKE, Helmut, D-89547 Gerstetten (DE)
(74) Vertreter: Maute, Hans-Jürgen, Dipl.-Ing.
(86) Internationale Anmeldenummer: EP9303462
(87) Internationale Veröffentlichungsnummer: WO9414197

(56) Entgegenhaltungen:
- DE-A- 4 039 103
- IEEE ELECTRON DEVICE LETTERS Bd. 10, Nr. 12 , Dezember 1989 , NEW YORK US Seiten 534 - 536 G. L. PATTON ET AL. 'GRADED-SIGE-BASE, POLY-EMITTER HETEROJUNCTION BIPOLAR TRANSISTORS' in der Anmeldung erwähnt
- SOLID STATE ELECTRONICS Bd. 34, Nr. 7 , Juli 1991 , OXFORD GB Seiten 787 - 794 SHIH-CHIH CHEN ET AL. 'THE FABRICATION AND STUDY OF INGAASP/INP DOUBLE-COLLECTOR HETEROJUNCTION BIPOLAR TRANSISTORS'
- SUBRAMANIAN S I ET AL: "HETEROJUNCTION BIPOLAR TRANSISTORS USING SI-GE ALLOYS", IEEE TRANSACTIONS ON ELECTRON DEVICES, NEW YORK, USA, Oktober 1989, Band 36, Nr. 10, Seiten 2043 - 2064

## Beschreibung

Die Erfindung betrifft einen Bipolartransistor, insbesondere für sehr hohe Frequenzen.

Es besteht ein Bedarf an Transistoren für sehr hohe Frequenzen über 10¹⁰Hz. Hierzu gibt es bereits einige Realisierungsvorschläge.

So ist beispielsweise in Solid State Electronics, Vol. 33, No. 2, S. 199-204, 1990 ein Aufbau für einen Si/SiGe Heterobipolartransistor (HBT) mit einer stark p-dotierten SiGe-Basisschicht zwischen n-dotierten Si-Schichten für Kollektor und Emitter beschrieben. Eine zwischen Basisschicht und stark n-dotierter Kollektoranschlußschicht liegende Driftzone besteht aus einer schwach n-dotierten Si-Schicht, wodurch die Kollektor-Basis-Kapazität verringert und die Durchschlagfestigkeit erhöht wird. Die Driftzonen-Schicht wird der Literatur gewöhnlich als Teil des Kollektors bezeichnet.

In IEEE Electron Device Letters, Vol. 10, No. 12, Dez. 1989, S. 534-536 ist ein Si/SiGe-HBT mit einer SiGe-Basisschicht beschrieben, bei welchem der Ge-Gehalt innerhalb der Basis von der Emitterseite zur Kollektorseite hin zunimmt, wodurch aufgrund der dadurch variierenden Bandlücke ein basisinternes Driftfeld beabsichtigt ist, um den Transport der vom Emitter injizierten Ladungsträger durch die Basis zu beschleunigen.

Eine allgemeine Betrachtung des Einsatzes von SiGe-Mischkristallgittern in einem HBT ist in IEEE Transactions on Electron Devices, Vol. 36, No. 10, Okt. 1989, S. 2043-2064 gegeben, insbesondere auch Überlegungen zu pseudomorphem Wachstum von SiGe-Schichten auf einem Si-Substrat und die aus der Gitterverspannung resultierenden Einflüsse auf die Bandstruktur.

In der DE 40 39 103 A1 ist ein Si-Bipolartransistor beschrieben, bei welchem Emitter, Basis und Kollektor als lateral strukturierte planar dotierte Ebenen innerhalb eines Trägermaterials ausgeführt sind, wobei durch Ausführung des Trägermaterials im Bereich der Basisebene als SiGe-Mischkristall eine Vertiefung der Potentialmulde für Löcher im Valenzband angestrebt ist.

In Appl. Phys. Lett. 46 (11), Juni 1985, S. 1084-1086, ist ein GaAs-Transistor mit einer δ(p⁺) -dotierten Basis zwischen gering n-dotierten Injektions- und Driftzonen beschrieben. Die Höhe der durch die Basisschicht gebildeten Potentialbarriere kann durch eine an die Basis angelegte Spannung gesteuert werden. Der Strom über die Barriere kann nach der Theorie der thermionischen Emission beschrieben werden.

Aufgabe der vorliegenden Erfindung ist es, einen Bipolartransistor für sehr hohe Frequenzen anzugeben.

Die Erfindung ist in den Ansprüchen 1 und 2 beschrieben. Die Unteransprüche enthalten vorteilhafte Ausgestaltungen und Weiterbildungen der Erfindung.

Unter delta(δ)-Dotierung ist dabei eine Schichtdicke der Basisschicht zu verstehen, die kleiner ist als die Kohärenzlänge der Löcher in der Basis, so daß sich ein zweidimensionales Ladungsträgergas ausbildet. Die Kohärenzlänge der Löcher beträgt in Silizium ca. 10nm bei Raumtemperatur.

Eine energetische Aufspaltung eines Leitungsbandminimums mit einer zuvor mehrfachen Entartung in zwei energetisch getrennte Minima mit unterschiedlichen effektiven Massen ist zum Beispiel von pseudomorph auf Silizium gewachsenem SiGe bekannt. Silizium zeigt ein 6-fach entartetes Leitungsbandminimum, welches in einer in (100)-Richtung auf Si aufgewachsenen pseudomorphen SiGe-Schicht aufgespalten ist in ein energetisch tieferliegendes 4-fach entartetes Minimum und ein energetisch höher liegendes 2-fach entartetetes Minimum mit unterschiedlichen anisotropen effektiven Massen der Elektronen in den jeweiligen Leitungsbandminima. In Driftrichtung, d.h. parallel zur Wachstumsrichtung und senkrecht zu den Schichtenebenen, besitzen die Elektronen im tieferliegenden Leitungsbandminimum eine geringere effektive Masse, d.h. sind leichter als die Elektronen im energetisch höherliegenden Leitungsbandminimum.

Die δ-dotierte Basisschicht in Verbindung mit einer SiGe enthaltenden Driftzone zeigt ein besonders günstiges Hochfrequenzverhalten. Dies kann erklärt werden durch eine Funktion der Potentialbarriere der dünnen Basis als Massefilter für die injizierten Elektronen, das eine bevorzugte Injektion der Elektronen mit der geringeren effektiven Masse in Driftrichtung bewirkt.Die leichten Elektronen erreichen eine höhere Driftgeschwindigkeit im elektrischen Feld der Driftzone. Von besonderer Bedeutung ist der Germaniumgehalt in dem der Basisschicht zugewandten Teil der Driftzone.

Die Erfindung ist nachfolgend anhand von Ausführungsbeispielen unter Bezugnahme auf die Abbildungen noch eingehend veranschaulicht, ohne den Erfindungsgedanken auf die in den Beispielen gewählte Materialkombinationen einzuschränken.
FIG. 1a zeigt einen Bipolartransistor in Mesabauweise mit einer n⁺-n-δp-n-n⁺-Struktur
FIG. 1b gibt den Ge-Anteil in der Basisschicht an
FIG. 1c zeigt die Dotierprofile und die schematischen Energiebandverläufe
FIG. 2a zeigt einen planaren Bipolartransistor mit einer δn-n-δp-n-n⁺-Struktur
FIG. 2b gibt den Ge-Anteil in der Basisschicht an
FIG. 2c zeigt die Dotierprofile und die schematischen Energiebandverläufe.

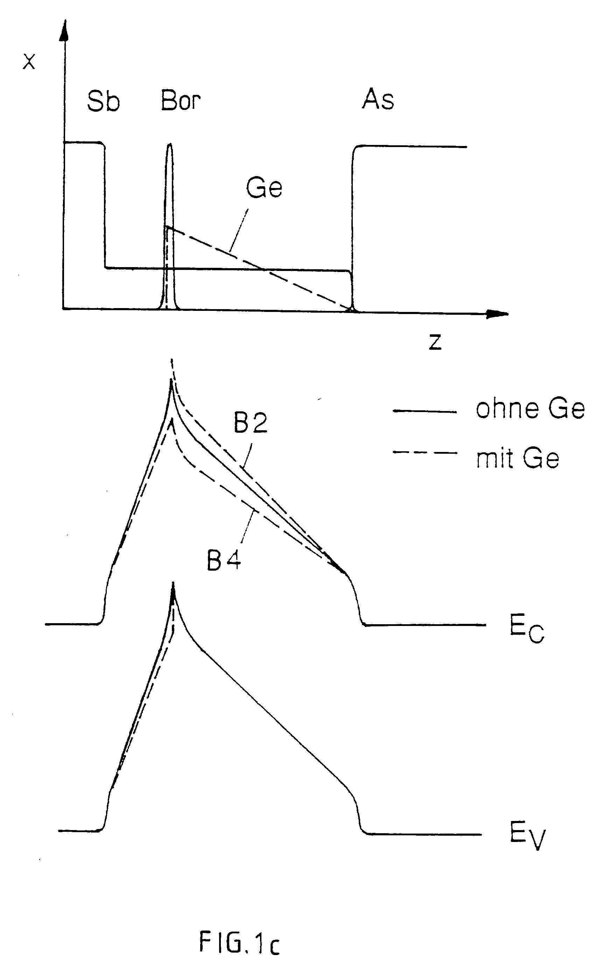

Der in FIG. 1a skizzierte Aufbau eines Bipolartransistors in Mesabauweise besitzt eine n⁺-n-δp-n-n⁺ Schichtenfolge. Die unterste Schicht 1 besteht aus n⁺-dotierten Silizium mit einer Dotierstoffkonzentration von z.B. 10²⁰ cm⁻³ und bildet die Kollektoranschlußschicht. Die darauf aufgewachsene Schicht 2 ist schwach n-dotiert mit einer Dotierstoffkonzentration von z.B. 5 ·10¹⁶ cm⁻³ und bildet die Driftzone. Diese Schicht 2 wird häufig auch als Teil des Kollektors bezeichnet. Die Weite L2 der Driftzone beträgt z.B. 100nm. Die Schicht 2 enthält pseudomorph gewachsenes SiGe. Der Germaniumgehalt x im Si₁₋ₓGeₓ-Mischkristall liegt unter x=0,4 vorzugsweise bei x < 0,2 mit einer von der Kollektorseite zur Basisseite hin zunehmenden Ge-Konzentration. Der Germaniumgehalt in der Driftzone ist vorzugsweise maximal bei der Schichtgrenze zur Basisschicht. Der Germaniumgehalt in der Basisschicht ist weitgehend unkritisch.

Die Driftzone kann auch nur in einem der Basisschicht zugewandten Bereich, der lediglich einem Teil der Weite L2 ausmacht, aus pseudomorph gewachsenem SiGe und in dem der Kollektorschicht 1 zugewandtem Teil der Driftzone aus Si bestehen, wobei der SiGe-Bereich vorteihafterweise mindestens 20% der Driftzonenweite L2 von der Basisschicht her einnimmt. Vorzugsweise liegt der Germaniumgehalt in einer Schichtdicke von mindestens 20nm höher als 10%. Der Verlauf des Germaniumgehalts kann in der ganzen Driftzone konstant sein oder vorzugsweise linear oder monoton oder auch in Stufen von der Basisschichtseite der Driftzone her abfallen.

Die Basisschicht 3 ist δp-dotiert, wobei die Dotierung aufgrund der geringen Dicke der Basisschicht mit nur wenigen nm als Flächendotierung angegeben werden kann mit einer Dotierstoffkonzentration von z.B. 10¹⁴ cm⁻². Die Basisschicht besteht aus Si oder aus pseudomorph gewachsenem SiGe vorzugsweise mit einem konstanten Ge-Gehalt, der gleich dem Ge-Gehalt der Driftzone an der Grenze zur Basisschicht ist.

Die Schicht 4 ist eine schwach n-dotierte Si-Schicht mit einer Dotierstoffkonzentration von z.B. 5 ·10¹⁶ cm⁻³ und bildet die Injektionszone. Die Weite L1 der Injektionszone beträgt beispielsweise 50 nm. Die Injektionszone wird häufig als Teil des Emitters bezeichnet.

Die Schicht 5 besteht aus n⁺-dotiertem Silizium mit einer Dotierstoffkonzentration von z.B. 10²⁰ cm⁻³ und einer Schichtdicke von z.,B. 100nm und bildet eine niederohmige Emitterkontaktschicht.

Als Dotierstoffe werden vorzugsweise Bor (B) für die Basisschicht und Arsen (As ) oder Antimon (Sb) für die n-bzw. n⁺-dotierten Schichten eingesetzt.

Mit E, B und C sind die metallischen Kontakte für Emitter, Basis und Kollektor bezeichnet.

Die Breite S_{E} des Emitters betrage beispielsweise 1µm, der Basis-Emitter-Abstand S etwa 0,5µm. Der Bipolartransistor ist in konventioneller Weise herstellbar.

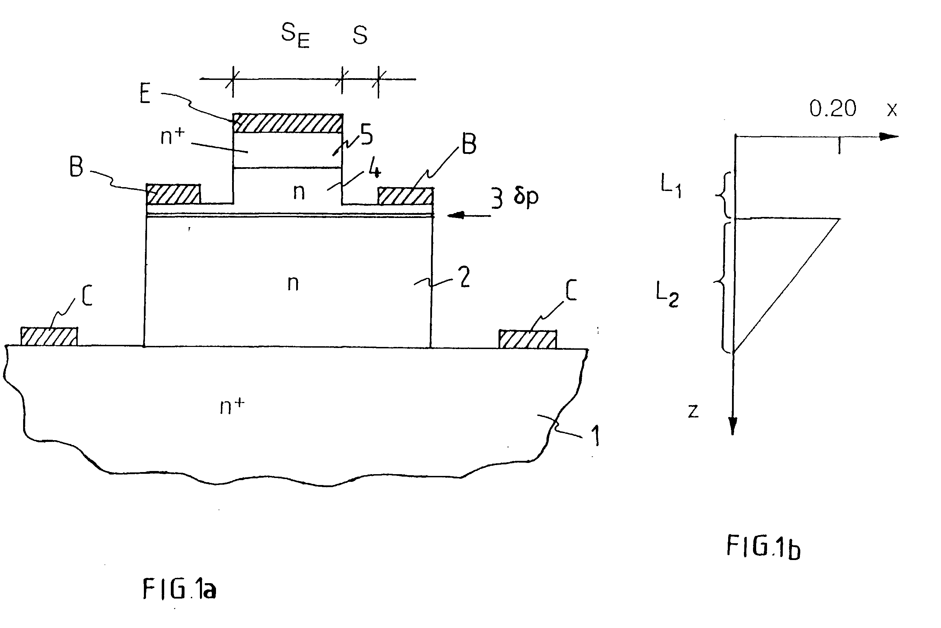

Enthält die Driftzone an der Grenze zur Basisschicht einen Ge-Anteil von z.B. x ≤ 0,2 mit einer Ge-Verteilung entsprechend FIG. 1b, so erzielt man kürzere Transitzeiten in der Driftzone , da durch ein pseudomorphes Wachstum von SiGe auf Si (001) eine Aufspaltung des 6-fach entarteten Leitungsbandminimums in der Driftzone in ein 2- und 4-fach entartetes Minimum stattfindet (FIG. 1c) und die Ladungsträger bevorzugt von der Injektionszone in das energetisch günstigere 4-fach entartete Minimum der Driftzone injiziert werden. Die Ladungsträger im energetisch abgesenkten, 4-fach entarteten Minimum besitzen in Driftrichtung eine geringere effektive Masse und damit eine erhöhte Driftgeschwindigkeit.

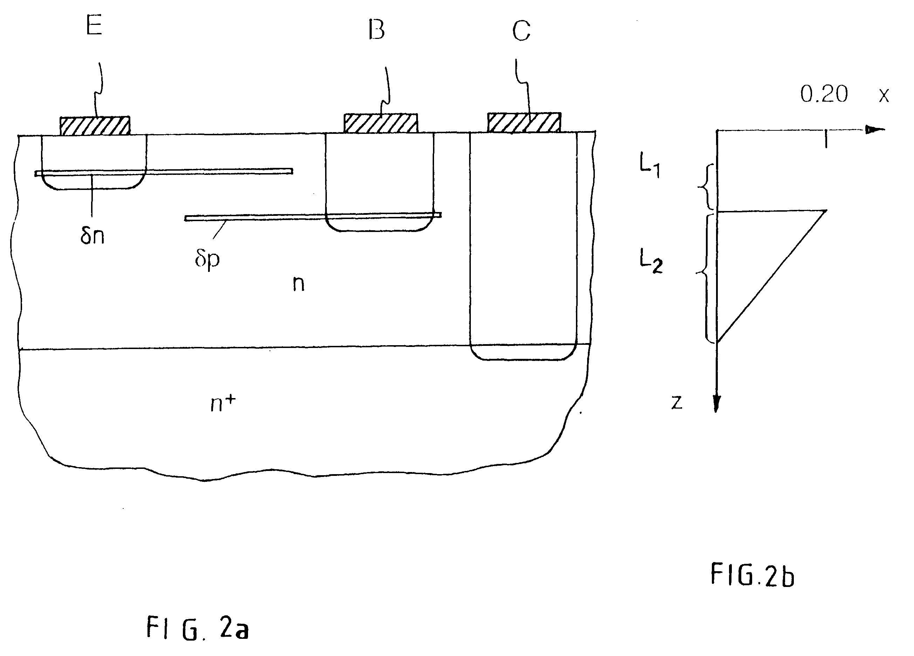

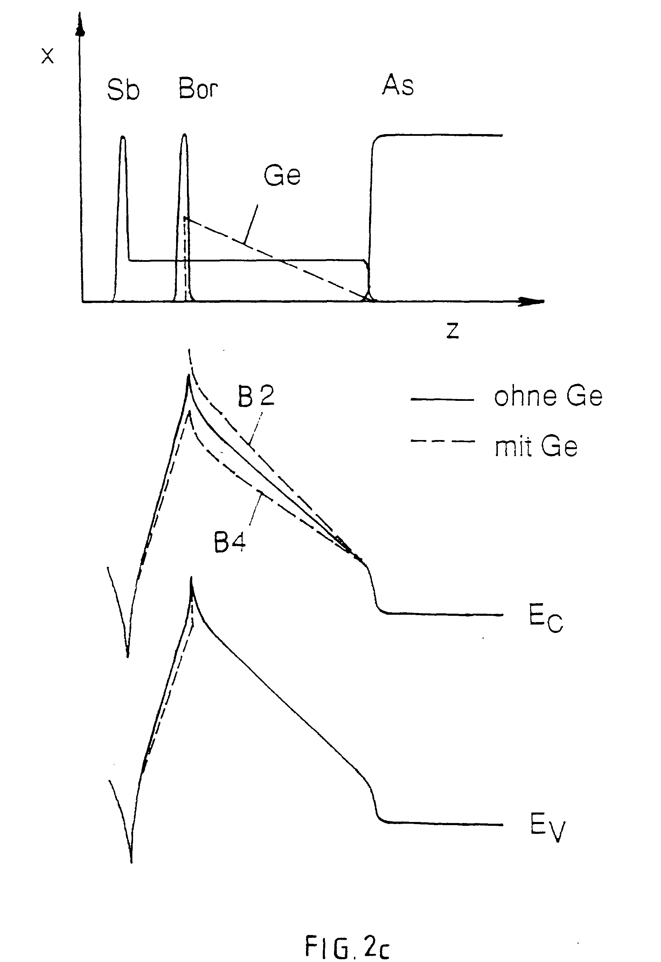

In FIG. 2a ist eine Bipolartransistor-Struktur dargestellt, die sowohl eine δ-dotierte Basis als auch einen 6-dotierten Emitter enthält. Durch eine derartige Struktur werden die Speicherzeiten für Minoritätsträger (Elektronen in der Basis, Defektelektronen im Emitter) merklich verringert. Beispielsweise wird auf einer n⁺-dotierten Kollektorschicht aus Silizium mit einer Ladungsträgerkonzentration von z.B. 10²⁰ As/cm³ eine etwa 100nm dicke Siliziumschicht mit einer Ladungsträgerkonzentration von etwa 5·10¹⁶ cm⁻³ aufgebracht. Mittels geeigneter Masken werden in einem Abstand von ca. 100nm von der Kollektorschicht in die n-dotierte Siliziumschicht eine erste δ-Dotierung δp mit einer Flächendotierung von z.B. 10¹⁴ B/cm² für die Basis und etwa 50nm oberhalb der δp-Dotierung eine zweite 6-Dotierung δn mit einer Flächendotierung von z.B. 10¹⁴ Sb/cm² eingebracht. Anschließend werden durch Kontaktimplantation Kontaktzonen erzeugt, die die aktive Bauelementbereiche mit den auf der Oberfläche der Schichtenfolge planar angeordneten Kontakten verbinden. Enthält die Driftzone zwischen Kollektorschicht und der ersten δ-Dotierung δp einen Ge-Anteil gemäß FIG. 2b so wird wie oben beschrieben die Driftgeschwindigkeit in vorteilhafter Weise erhöht. Die zur planaren Bipolartransistor-Struktur zugehörigen Dotierungen und die Energiebandverläufe sind in FIG. 2c dargestellt.

Mit den angegebenen rauscharmen Bipolartransistoren werden Grenzfrequenzen fₘₐₓ von über 100GHz erzielt.

Die Erfindung ist nicht auf die angegebenen Transistorstrukturen beschränkt, sondern es sind auch Transistoren mit p+-p-δn-p-p⁺- sowie δp-p-6n-p-p⁺-Strukturen herstellbar, für welche dann auch die vorstehend für die Leitungsbandstruktur ausgeführten Eigenschaften auf die Valenzbandstruktur zu übertragen ist.

Die Erfindung ist auch nicht auf die beispielhaft gewählte und besonders'gut erforschte Materialkombination Si/SiGe eingeschränkt, sondern allgemein auf Halbleitermaterialien anwendbar welche die Leitungsbandaufspaltung mit einem für in Driftrichtung leichte Elektronen tieferliegenden Leitungsbandminimum zeigen, wie z.B. AlAs.

## Patentansprüche

1. Bipolartransistor mit einer delta-p-dotierten Basisschicht (3) und einer Driftzone (2) zwischen der Basisschricht und einer n⁺-dotierten Kollektoranschlußschicht (1), bei dem
- die Driftzone zumindest in einem basisseitigen Bereich aus einem Halbleitermaterial mit einer aufgespaltenen Leitungsbandstruktur besteht, deren mehrfach entartetes Leitungsbandminimum zumindest in zwei energetisch getrennte Leitungsbandminima mit unterschiedlich anisotropen effektiven Massen der Elektronen aufgespalten ist,
- das energetisch tieferliegende Leitungsbandminimum Elektronen mit einer geringeren effektiven Masse enthält, die in Driftrichtung energetisch bevorzugt sind, und
- die Driftzone schwach n-dotiert ist.

2. Bipolartransistor mit einer delta-n-dotierten Basisschicht (3) und einer Driftzone (2) zwischen der Basisschicht und einer p⁺-dotierten Kollektoranschlußschicht (1), bei dem
- die Driftzone zumindest in einem basisseitigen Bereich aus einem Halbleitermaterial mit einer aufgespaltenen Valenzbandstruktur besteht, deren mehrfach entartetes Valenzbandmaximum zumindest in zwei energetisch getrennte Valenzbandmaxima mit unterschiedlich anisotropen effektiven Massen den Löcher aufgespalten ist,
- das energetisch höher liegende Valenzbandmaximum Löcher mit einer geringeren effektiven Masse enthält, die in Driftrichtung energetisch bevorzugt sind, und
- die Driftzone Schwach p-dotiert ist

3. Transistor nach einem der Ansprüche 1 und 2, dadurch gekennzeichnet, daß der Bereich mindestens 20% der Weite (L2) der Driftzone umfaßt.

4. Transistor nach einem der Ansprüche 1 bis 3, dadurch gekennzeichnet, daß die Energieaufspaltung der Leitungsbandstruktur in der Driftzone in Driftrichtung variiert und ihren Maximalwert an der Schichtgrenze zur Basisschicht erreicht.

5. Transistor nach einem der Ansprüche 1 bis 4, dadurch gekennzeichnet, daß der Bereich mit aufgespaltener Leitungsbandstruktur aus pseudomorph in (100) -Orientierung auf Si gewachsenem SiGe besteht.

6. Transistor nach Anspruch 5, dadurch gekennzeichnet, daß der Ge-Gehalt in der Driftzone von 0% an der Grenze zur Kollektoranschlußschicht auf maximal 40 % an der Basis ansteigt.

7. Transistor nach einem der Ansprüche 4 und 5, dadurch gekennzeichnet, daß die Basisschicht aus pseudomorph gewachsenen SiGe besteht.

8. Transistor nach einem der Ansprüche 4 bis 6, dadurch gekennzeichnet, daß die Weite der Basisschicht kleiner als 10 nm ist.

9. Transistor nach einem der Ansprüche 1 und 3 bis 8, dadurch gekennzeichnet, daß die Basischicht eine p-Flächendotierung von mindestens 10¹³ Dotieratome/cm² aufweist.

10. Transistor nach einem der Ansprüche 1 und 3 bis 9, dadurch gekennzeichnet, daß der Emitter als delta-n-dotierte Schicht ausgeführt ist.

11. Transistor nach Anspruch 2, dadurch gekennzeichnet, daß der Emitter als delta-p-dotierte Schicht ausgeführt ist.

12. Transistor nach einem der Ansprüche 1 bis 11, dadurch gekennzeichnet, daß der Transistor in Mesa-Bauweise ausgeführt ist.

## Claims

1. Bipolar transistor with a delta-p-type doped base layer (3) and a drift zone (2) between the base layer and an n⁺-type doped collector terminal layer (1), in which
- the drift zone consists at least in a region on the base side of a semiconductor material with a split conduction band structure, the multiply degenerate conduction band minimum of which is split at least into two conduction band minima of different energy levels with effective electron masses which are anisotropically different,
- the conduction band minimum of lower energy level contains electrons with a lower effective mass, which are energetically preferred in the drift direction, and
- the drift zone is weakly doped n-type.

2. Bipolar transistor with a delta-n-type doped base layer (3) and a drift zone (2) between the base layer and a p⁺-type doped collector terminal layer (1), in which
- the drift zone consists at least in a region on the base side of a semiconductor material with a split valence band structure, the multiply degenerate valence band maximum of which is split at least into two valence band maxima of different energy levels with effective hole masses which are anisotropically different,
- the valence band maximum of higher energy level contains holes with a lower effective mass, which are energetically preferred in the drift direction, and
- the drift zone is weakly doped p-type.

3. Transistor according to any one of Claims 1 and 2, characterised in that the region covers at least 20% of the width (L2) of the drift zone.

4. Transistor according to any one of Claims 1 to 3, characterised in that the energy splitting of the conduction band structure in the drift zone varies in the drift direction and reaches its maximum value at the layer boundary with the base layer.

5. Transistor according to any one of Claims 1 to 4, characterised in that the region with the split conduction band structure consists of SiGe grown pseudomorphously in (100)-orientation on Si.

6. Transistor according to Claim 5, characterised in that the Ge content in the drift zone increases from 0% at the boundary with the collector terminal layer to a maximum of 40% at the base.

7. Transistor according to any one of Claims 4 and 5, characterised in that the base layer consists of pseudomorphously grown SiGe.

8. Transistor according to any one of Claims 4 to 6, characterised in that the width of the base layer is less than 10 nm.

9. Transistor according to any one of Claims 1 and 3 to 8, characterised in that the base layer comprises a p-area doping of at least 10¹³ doping atoms/cm².

10. Transistor according to any one of Claims 1 and 3 to 9, characterised in that the emitter is formed as a delta-n-type doped layer.

11. Transistor according to Claim 2, characterised in that the emitter is formed as a delta-p-type doped layer.

12. Transistor according to any one of Claims 1 to 11, characterised in that the transistor is of mesa construction.

## Revendications

1. Transistor bipolaire comportant une couche de base (3) dopée selon un dopage delta-p et une zone de dérive (2) située entre la couche de base et une couche (1) de borne de collecteur, dopée de type n⁺, dans lequel
- la zone de dérive est constituée, au moins dans une région située du côté de la base, par un matériau semiconducteur possédant une structure de bande de conduction divisée, dont le minimum de la bande de conduction, qui est dégénéré de façon multiple, est divisé au moins en deux minima de bande de conduction séparés du point de vue énergétique avec des masses effectives anisotropes différentes des électrons,
- le minimum de la bande de conduction, qui est plus bas du point de vue énergétique, contient des électrons ayant une masse effective plus faible et qui sont préférés du point de vue énergétique dans la direction de dérive, et
- la zone de dérive est faiblement dopée du type n.

2. Transistor bipolaire comportant une couche de base (3) dopée selon un dopage delta-p et une zone de dérive (2) située entre la couche de base et une couche (1) de borne de collecteur, dopée de type n⁺, dans lequel
- la zone de dérive est constituée, au moins dans une région située du côté de la base, par un matériau semiconducteur possédant une structure de bande de valence divisée, dont le minimum de la bande de valence, qui est dégénéré de façon multiple, est divisé au moins en deux maxima de la bande de valence séparés du point de vue énergétique, avec des masses effectives anisotropes différentes des trous,
- le maximum de la bande de valence, qui est plus élevé du point de vue énergétique, contient des trous possédant une masse effective plus faible, qui sont préférés du point de vue énergétique dans la direction de dérive, et
- la zone de dérive est faiblement dopée du type p.

3. Transistor selon l'une des revendications 1 et 2, caractérisé en ce que la région s'étend sur au moins 20 % de la largeur (L2) de la zone de dérive.

4. Transistor selon l'une des revendications 1 à 3, caractérisé en ce que la division d'énergie de la structure de bande de conduction dans la zone de dérive varie dans la direction de dérive et prend sa valeur maximale au niveau de l'interface avec la couche de base.

5. Transistor selon l'une des revendications 1 à 4, caractérisé en ce que la région possédant la structure de bande de conduction divisée est constituée par du SiGe formé au moyen d'une croissance pseudomorphe avec l'orientation (100) sur du Si.

6. Transistor selon la revendication 5, caractérisé en ce que la teneur en Ge dans la zone de dérive augmente depuis 0 % au niveau de la limite avec la couche de raccordement de collecteur jusqu'au maximum à 40 % au niveau de la base.

7. Transistor selon l'une des revendications 4 et 5, caractérisé en ce que la couche de base est constituée par du SiGe formé par croissance pseudomorphe.

8. Transistor selon l'une des revendications 4 à 6, caractérisé en ce que la largeur de la couche de base est inférieure à 10 nm.

9. Transistor selon l'une des revendications 1 et 3 à 8, caractérisé en ce que la couche de base possède un dopage superficiel de type p égal au moins à 10¹³ atomes de dopant/cm².

10. Transistor selon l'une des revendications 1 et 3 à 9, caractérisé en ce que l'émetteur est agencé sous la forme d'une couche dopée au moyen d'un dopage delta-n.

11. Transistor selon la revendication 2, caractérisé en ce que l'émetteur est agencé sous la forme d'une couche dopée selon un dopage delta-p.

12. Transistor selon l'une des revendications 1 à 11, caractérisé en ce que le transistor est agencé dans la forme de réalisation mesa.
